# EUROPEAN PATENT APPLICATION

(11) **EP 4 598 046 A1**
(43) Date of publication of application: **06.08.2025**
(21) Application number: 25155746.8
(22) Date of filing: 04.02.2025
(51) Int. Cl.: H04Q 1/02

(54) **CAGE DESIGN FOR VERTICAL LINE CARD**

(30) Priority: 05.02.2024 US 202418432588
(71) Applicant: Google LLC, Mountain View, CA 94043 (US)
(72) Inventor: LIU, Melody, Mountain View, California, 94043 (US); EDWARDS, William F., Jr., Mountain View, California, 94043 (US); LIU, Tanya, Mountain View, California, 94043 (US); LAM, Cedric, Fung, Mountain View, California, 94043 (US); MAJUMDAR, Ayan, Mountain View, California, 94043 (US)
(74) Representative: Betten & Resch

(57) **Abstract**

The present disclosure is generally directed to a vertical line card configuration with cage assemblies mounted perpendicular to a printed circuit board with an application specific integrated circuit. The cage assembly may include a plurality of pluggable modules arranged in a belly-to-belly configuration. In this configuration, a first pluggable module having an internal heatsink on bottom may be arranged in vertical alignment with a similar but inverted module where the internal heatsink is on top by virtue of the inversion. The vertical cage structure may include riding heatsinks on opposing edges parallel to the internal heatsinks in the pluggable modules. The cage structure may also have a 2xn cage design, including two cage rows of pluggable modules and any number of columns of module pairs.

## Description

### BACKGROUND

Vertical line cards are an improvement in data center architecture. Conventional data center architectures use horizontal line cards that typically include an application specific integrated circuit (ASIC) with pluggable cages in horizontally stacked rows on both the front and back of the horizontal circuit board. As a result, signal traces are long because signals must travel from the back side of the ASIC to the furthest away pluggable cage on the front panel. On the other hand, vertical line cards typically have an ASIC located between at least two pluggable cages, which results in shorter trace lengths and better signal integrity.

However, compared to horizontal line cards, vertical line cards have decreased mechanical strength and an increased cooling need to prevent degradation of the ASIC and other delicate device components. Vertical line cards are sometimes cooled using heatsinks, which typically transfer heat from a device to surrounding air and thus dissipate heat away from the device. Specifically, some vertical line cards use either riding or internal heatsinks as a cooling mechanism.

### BRIEF SUMMARY

The present disclosure is generally directed to a vertical line card configuration with cage assemblies mounted perpendicular to a printed circuit board with an application specific integrated circuit. The cage assembly may include a plurality of pluggable modules arranged in a belly-to-belly configuration. In this configuration, a first pluggable module having an internal heatsink on bottom may be arranged in vertical alignment with a similar but inverted module where the internal heatsink is on top by virtue of the inversion. The vertical cage structure may include riding heatsinks on opposing edges parallel to the internal heatsinks in the pluggable modules. The cage structure may also have a 2xn cage design, including two cage rows of pluggable modules and any number of columns of module pairs. A further aspect is directed to cooling the vertical line card using the riding heatsinks on the cage structure and the internal heatsinks in the pluggable modules, which may be oriented in the belly-to-belly configuration. The present disclosure is also generally directed to a cage structure on a vertical line card having the 2 x n design, including, but not limited to, a 2 x 4 design.

One aspect of the disclosure is directed to a cage structure comprising a first end and a second end. The first end may be adapted to be coupled to a vertical line card such that the second end of the cage structure is laterally displaced from the first end. The cage structure may have a top edge and a bottom edge extending between the first and second ends. The cage structure may also have at least two vertically aligned cavities extending between the first end and the second end and between the top edge and the bottom edge. The top edge and the bottom edge may be adapted to accommodate a riding heatsink.

In some examples, the cage structure may comprise a middle edge between and parallel to the top and bottom edges. The middle edge may comprise a first middle surface facing the top edge and a second middle surface facing the bottom edge. The top edge may comprise a top external surface on a perimeter of the cage structure and a top internal surface facing the first middle surface. The bottom edge may comprise a bottom internal surface facing the second middle surface and a bottom external surface on the perimeter of the cage structure.

In some examples, the at least two vertically aligned cavities may comprise a first cavity between the top internal surface and the first middle surface and a second cavity between the second middle surface and the bottom internal surface.

In some examples, the first riding heatsink may reside on the top external surface and a second riding heatsink may reside on the bottom external surface.

Another aspect of the disclosure is directed to a cage assembly comprising a cage structure, and a first and second riding heatsink. The cage structure may have a first end and a second end. The first end may be adapted to be coupled to a vertical line card such that the second end of the cage structure is laterally displaced from the first end. The cage structure may also have a top edge and a bottom edge extending between the first and second ends. The cage structure may also have at least two vertically aligned cavities extending between the first end and the second end and between the top edge and the bottom edge.

In some examples, the first riding heatsink may be connected to the top edge of the cage structure, and a second riding heatsink may be connected to the bottom edge of the cage structure. A module pair may be encased within the cage structure. The module pair may comprise two vertically aligned pluggable modules respectively residing within the at least two vertically aligned cavities of the cage structure.

In some examples, the cage structure may comprise a middle edge between and parallel to the top and bottom edges, the middle edge comprising a first middle surface facing the top edge and a second middle surface facing the bottom edge. The top edge may comprise a top external surface on a perimeter of the cage structure and a top internal surface facing the first middle surface. The bottom edge may comprise a bottom internal surface facing the second middle surface and a bottom external surface on the perimeter of the cage structure.

In some examples, a top one of the pluggable modules may comprise a first internal heatsink between the top internal surface and the first middle surface. The first internal heatsink may face the top internal surface of the cage structure. A bottom one of the pluggable modules may comprise a second internal heatsink between the second middle surface and the bottom internal surface. The second internal heatsink may face the bottom internal surface of the cage structure.

In some examples, the first and second internal heatsinks may be parallel to the first and second riding heatsinks.

In some examples, the first riding heatsink may have a first thickness, and the second riding heatsink may have a second thickness different from the first thickness.

Another aspect of the disclosure is directed to a system comprising a printed circuit board (PCB), an application specific integrated circuit (ASIC), and a vertical line card. The ASIC may be mountable on the PCB on the vertical line card such that the ASIC and the PCB both extend along a vertical plane. The system may additionally comprise a cage assembly mountable on the vertical line card. The cage assembly may comprise a cage structure and a first module pair. The cage structure may comprise two riding heatsinks connected to opposing external surfaces of the cage structure. The first module pair may reside within the cage structure and may comprise two vertically aligned pluggable modules.

In some examples, each pluggable module may comprise an internal heatsink parallel to the two riding heatsinks. The internal heatsinks of the two pluggable modules may face the at least one of a top edge and a bottom edge of the cage structure.

In some examples, the cage structure may comprise a top edge, a middle edge below and parallel to the top edge, and a bottom edge below and parallel to the top and middle edges. The middle edge may comprise a first middle surface facing the top edge and a second middle surface facing the bottom edge. The top edge may comprise a top external surface on a perimeter of the cage structure and a top internal surface facing the first middle surface. The bottom edge may comprise a bottom internal surface facing the second middle surface and a bottom external surface on the perimeter of the cage structure. The PCB may comprise a first internal heatsink cutout between the top internal surface and the first middle surface and a second internal heatsink cutout between the second middle surface and the bottom internal surface.

The cage assembly may comprise a space between the first and second internal heatsink cutouts on the PCB that defines a routing space.

In some examples, each pluggable module may comprise an optical connector on an end of each pluggable module. The optical connector may be configured to establish a data path between each pluggable module and traces of the PCB.

In some examples, the system may comprise at least one second module pair laterally adjacent to the first module pair.

In some examples, the cage assembly may be positioned relative to a first edge of the ASIC, and a second cage assembly may be positioned relative to a second opposing edge of the ASIC.

In some examples, the cage assembly may comprise at least two vertically aligned cavities sized to accommodate the module. The cage assembly may comprise at least two additionally vertically aligned cavities positioned laterally adjacent to the at least two vertically aligned cavities. The cage assembly may comprise four pairs of vertically aligned cavities forming a 2 x 4 configuration.

### BRIEF DESCRIPTION OF THE DRAWINGS

In the drawings, which are presented in simplified form and are not drawn to precise scale:
Figure 1 is a front view of a network switch having a 2 x 4 vertical octal small form factor pluggable (OSFP) board configuration.
Figure 2 is a perspective view of the network switch in Figure 1.
Figure 3A is a front view of a cage structure on a vertical line card.
Figure 3B is a side view of a module pair inserted into the cage structure of Figure 3A in a belly-to-belly configuration.
Figure 4 is a front view of a 2 x 4 cage structure with riding heatsinks.
Figure 5 is a perspective view of a 2 x 4 cage structure mounted to a vertical line card.
Figure 6 is a front view of a cage assembly having two 2x4 cage structures.
Figure 7 is a front view of a portion of the PCB corresponding to where a 2 x 4 cage structure would be attached.

### DETAILED DESCRIPTION

The present disclosure is generally directed to a vertical line card configuration with cage assemblies mounted perpendicular to a printed circuit board (PCB) with an application specific integrated circuit (ASIC). The cage assembly may include a plurality of pluggable modules arranged in a belly-to-belly configuration. In this configuration, a first pluggable module having an internal heatsink on bottom may be arranged in vertical alignment with a similar but inverted module where the internal heatsink is on top by virtue of the inversion. The vertical cage structure may include riding heatsinks on opposing edges parallel to the internal heatsinks in the pluggable modules. The cage structure may also have a 2xn cage design, including two cage rows of pluggable modules and any number of columns of module pairs. In some examples, the cage structures are octal small form factor pluggable (OSFP) cage structures, and the pluggable modules are OSFP modules.

This system design may enable more ports on one PCB and reduce high-speed signal trace lengths with improved signal integrity through a routing space between the two internal heatsinks.

The belly-to-belly configuration may enable flexibility with riding heatsink design, including taller riding heatsinks than conventional architectures or riding heatsinks of differing heights on opposing sides of a cage assembly. The flexibility with the height of the riding heatsinks results in flexibility with the cooling level of the device and therefore enables use in high power applications.

The 2 x n cage structure for the belly-to-belly configuration may increase the mechanical strength through the grouping of module pairs together and the reduced number of perforations on a vertical line card. Mechanical strength of a cage structure is especially imperative during the insertion of pluggable modules.

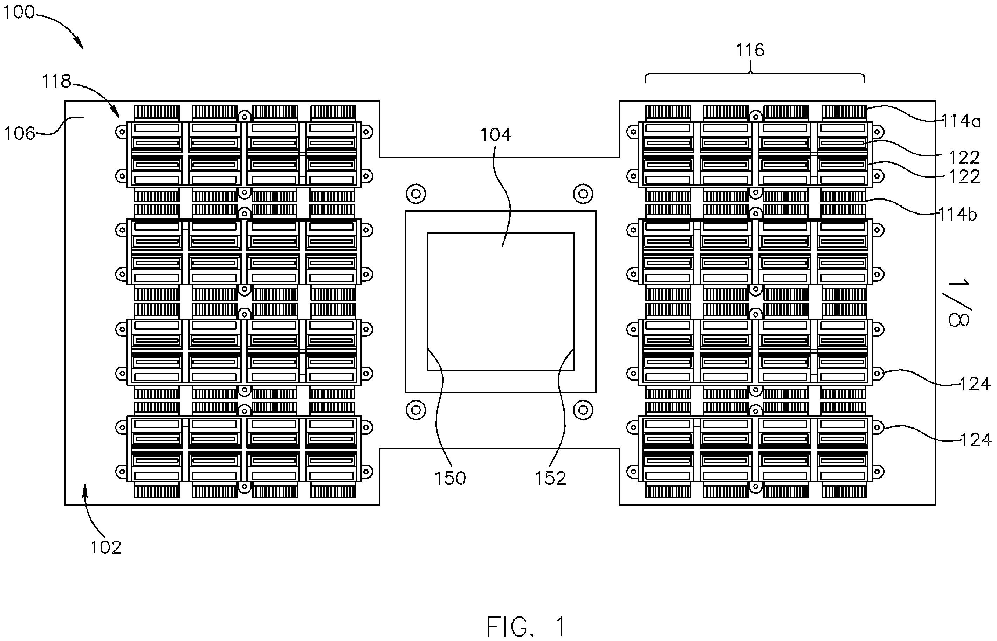

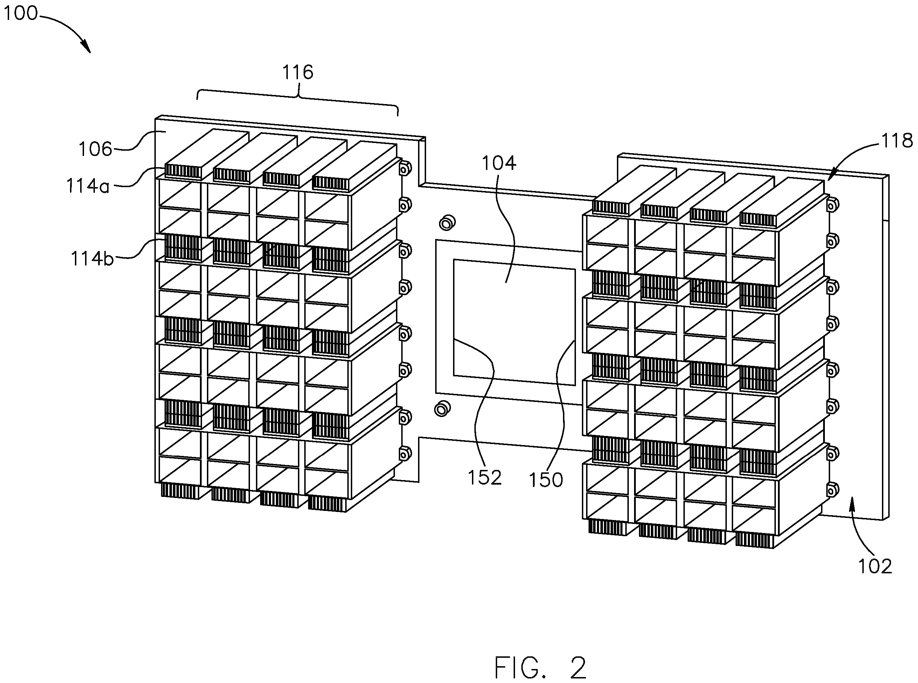

Figures 1 and 2 illustrate a network switch 100 having a 2 x 4 vertical OSFP board configuration. Vertical line card 102 may include a printed circuit board (PCB) 106 having an application specific integrated circuit (ASIC) 104 mounted thereon.

A cage assembly 116 may be mounted on the vertical line card 102 such that it extends laterally away from the PCB 106, such as in a direction perpendicular to the PCB 106. The cage structure 118 may have a top edge, a middle edge below and parallel to the top edge, and a bottom edge below and parallel to the top and middle edges. The middle edge may have a first middle surface 140 facing the top edge and a second middle surface 142 facing the bottom edge. The top edge may have a top external surface 136 on a perimeter of the cage structure 118 and a top internal surface 138 facing the first middle surface 140. The bottom edge may have a bottom internal surface 144 facing the second middle surface 142 and a bottom external surface 146 on the perimeter of the cage structure 118.

The cage structure 118 may have first riding heatsinks 114a connected to the top external surface 136 and second riding heatsinks 114b connected to the bottom external surface 146.

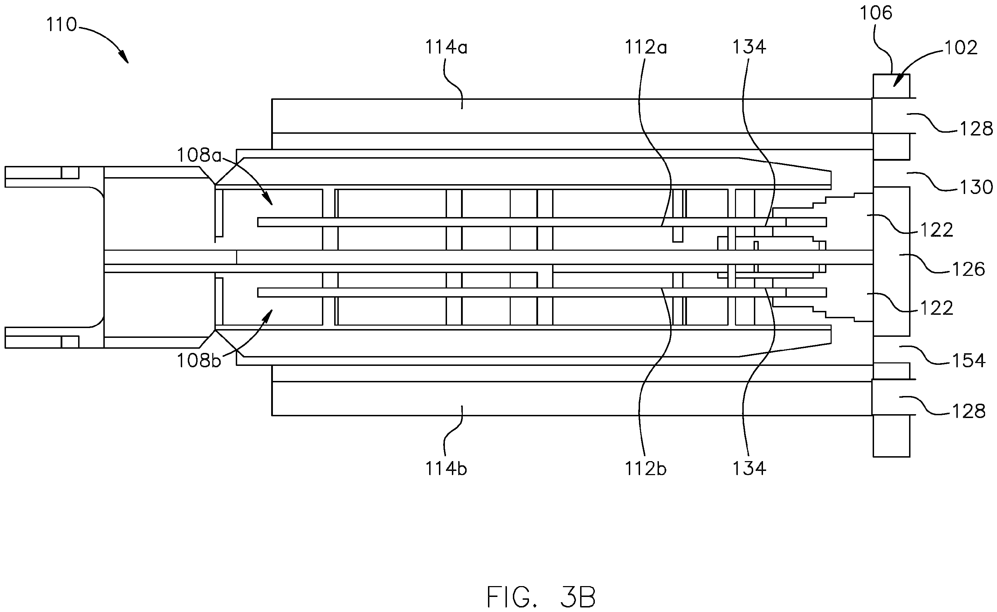

In some examples, cage assemblies 116 may be mounted on either side of the ASIC 104. By way of example, a first cage assembly 116 may be positioned relative to a first edge 150 of the ASIC 104, and a second cage assembly 116 may be positioned relative to a second edge 152 of the ASIC 104. The cage assembly 116 may include pluggable modules 108 having internal heatsinks 112 in modules pairs 110 plugged into a cage structure 118 having riding heatsinks 114, as described in further detail in connection to Figure 3B.

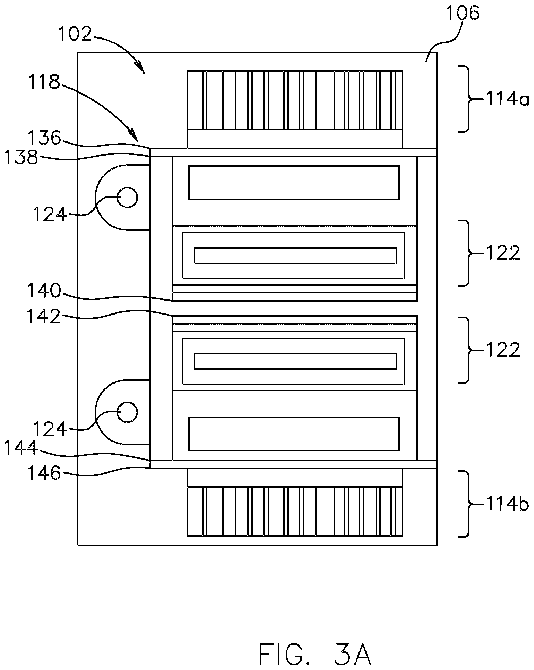

Figure 3A provides an enlarged view of a portion of the cage assembly, including the cage structure 118. The riding heatsinks 114 on cage structure 118 may be consistent in size and shape with respect to other riding heatsinks on the same cage structure. In other examples, a first riding heatsink may be different from a second riding heatsink. By way of example, the riding heatsinks residing along a top surface of the cage structure may have a first height or thickness, while the riding heatsinks residing along a bottom surface of the cage structure may have a second height or thickness that is different from the first height or thickness. For example, the top riding heatsinks may be taller than the bottom riding heatsinks, such as if more space is available near the top surface as compared to the bottom surface and/or great cooling is desired for the top riding heatsinks as compared to the bottom riding heatsinks.

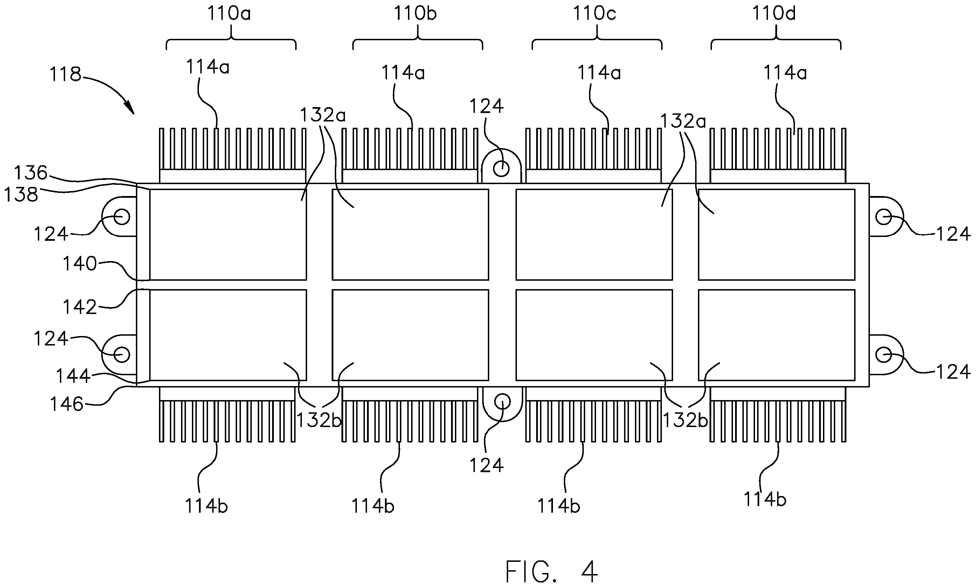

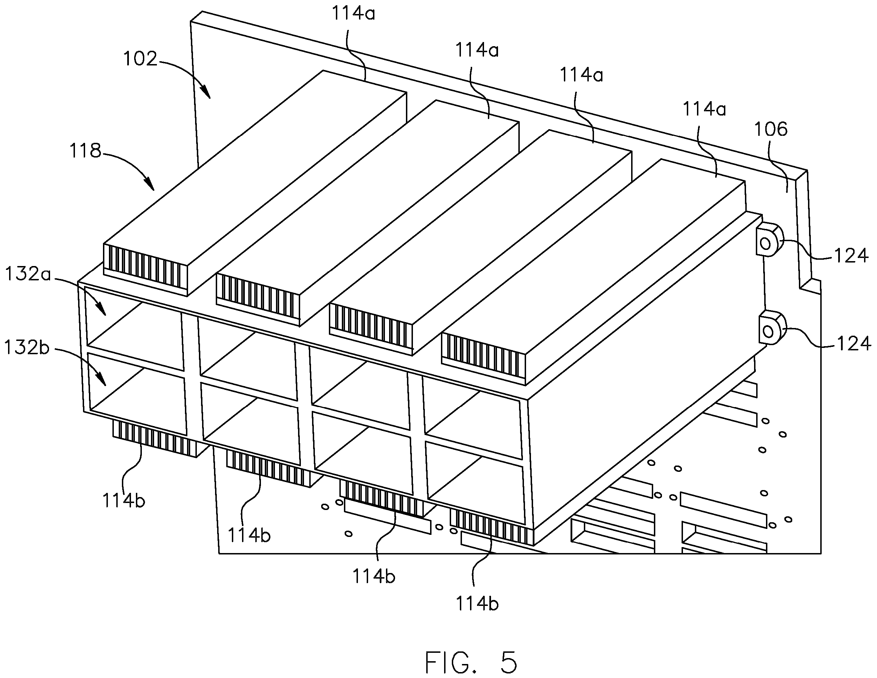

As shown in Figure 3B, pluggable modules 108 may be plugged into cavities 132 of the cage structure 118. The cavities 132 are depicted and described in further detail in connection to Figures 4 and 5.

Each pluggable module 108 may include internal heatsinks. For example, the top module as shown may include a first internal heatsink 112a, and the bottom module as shown may include a second internal heatsink 112b. The first internal heatsink 112a may reside between the first middle surface 140 and the top internal surface 138, and the first internal heatsink 112a may face the top internal surface 138. The second internal heatsink 112b may reside between the second middle surface 142 and the bottom internal surface 144, and the second internal heatsink 112b may face the bottom internal surface 144.

Internal heatsink 112 can otherwise be referred to as an integrated heatsink. The internal heatsink 112 may be used to add thermal margin and maintain low fan speed in higher powered optical modules. Specifically, internal heatsink 112 may passively dissipate heat generated by a device to ambient air.

The internal heatsink 112 may be at least partially made of a material that has high heat capacity and thermal conductivity, including, but not limited to, aluminum alloys, copper, etc. The internal heatsink 112 may be created through extrusion, casting, skiving, milling, or any other method of creating internal heatsinks known in the art.

The internal heatsink 112 may be substantially rectangular with fins extruding from one side. The fins on internal heatsink 112 may be a series of flat plates that, due to their additional surface area, absorb heat from a device and dissipate the heat from an end of the fin closest to the internal heatsink 112 to an end farthest from the internal heatsink 112. For example, the internal heatsink 112 may be a pin fin heatsink with several columns and rows of fins extending from the one side on internal heatsink 112. In some examples, the internal heatsink 112 may be a straight fin heatsink with several columns and one row of fins extending from the one side on internal heatsink 112. In some examples, the internal heatsink 112 may be a flared fin heatsink with several columns and one row of fins extending from the one side on internal heatsink 112 at different angles and not parallel to each other. In other examples, the internal heatsink 112 may have inverted fins as crevices within the one side on internal heatsink 112 to extract heat from a device to internal heatsink 112.

The internal heatsink 112 may be attached to the pluggable module 108 using thermally conductive tape or epoxy, wire-form z clips, flat spring clips, standoff spacers, push pins with ends that expand after installing, or any other method of attaching internal heatsinks known in the art.

The vertical line card 102 may further include a conductive thick plate between a heat source of a device and internal heatsink 112 to improve the heat transfer away from the heat source.

A module optical connector 134 may be located on the pluggable module 108, and a board optical connector 122 may be located between a first internal heatsink cutout 130 and a second internal heatsink cutout 154 on the vertical line card 102. The module optical connector 134 may be used to establish a data path between the pluggable module 108 and traces of the PCB 106 by plugging an end of the pluggable module 108 comprising the module optical connector 134 into a cavity 132 on the cage structure 118 and receiving the board optical connector 122. The cavities 132 are depicted and described in further detail in connection to Figures 4 and 5.

The pluggable modules 108 may be aligned in the cage structure 118 in a belly-to-belly configuration, forming a module pair 110. In this configuration, two pluggable modules 108 may be vertically aligned, and a bottom module 108b may be inverted, or rotated 180 degrees, with respect to the top module 108a. In this regard, underside portions of the two modules 108 are adjacent to each other, while upper portions of the modules 108 extend away from each other. The pluggable modules 108 may be inserted into cavity 132 of the cage structure 118, such that a module optical connector 134 at an end of the pluggable module 108 engages with routing traces on the vertical line card 102.

The belly-to-belly configuration enables high speed traces to be routed to an inner middle section that is a routing space 126 space between the first internal heatsink cutout 130 and the second internal heatsink cutout 154 on the PCB 106.

The belly-to-belly configuration also facilitates differing heights of riding heatsinks 114 above or below the module pairs 110 without the need for design changes. The differing heights may be useful to accommodate more or less cooling. For example, the cage structure may have taller riding heatsinks 114 on one side than the other of the module pair 110. By way of example, top riding heatsink 114a may have a first height, while bottom riding heatsink 114b may have a second height that is greater or lesser than the first height. While the riding heatsinks 114a and 114b may have any height, they may generally range from 1 mm to 50 mm. Additionally, the cage structure may accommodate taller riding heatsinks 114 than conventional cages are able to accommodate. For example, riding heatsinks 114 may be a length that is beneficial for high power applications.

The cage structure 118 may be secured to the vertical line card 102 through mounting holes 124 in the cage structure 118 and the vertical line card 102. A fastener, such as, but not limited to, a press-fit pin or screw, may be inserted into the mounting holes 124 to secure the cage structure 118 to the vertical line card 102.

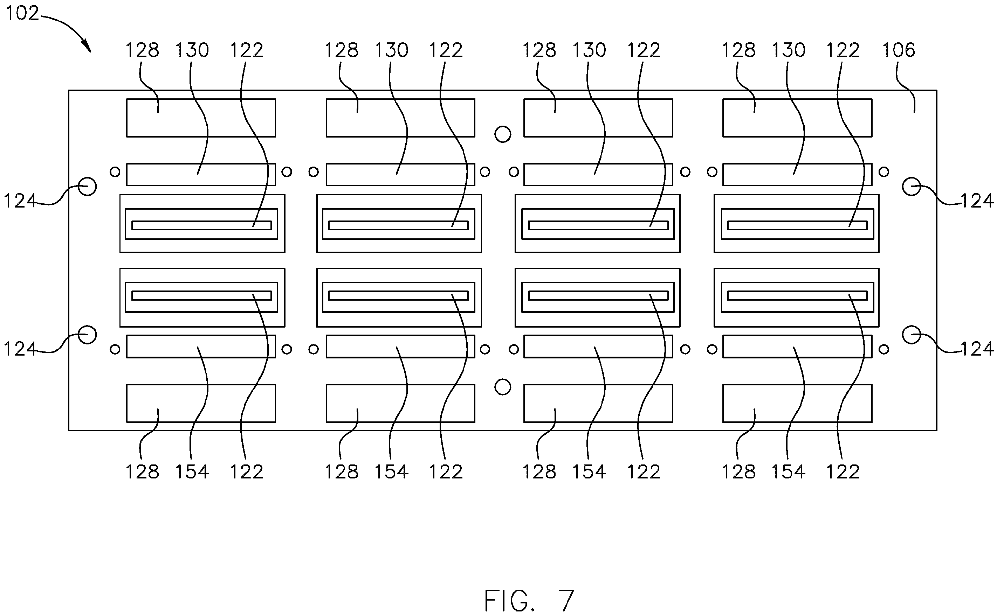

The PCB 106 and vertical line card 102 may include riding heatsink cutouts 128 and internal heatsink cutouts 130 and 154 configured to receive the heatsinks, as described in further detail in connection with Figure 7.

FIGS. 4 and 5 illustrate a 2 x 4 cage design. In a 2 x 4 cage design, two pluggable modules 108 may be positioned in two cage rows and four columns of pluggable modules 108. By way of example, a first module pair 110a may be laterally adjacent to a second module pair 110b, which may be laterally adjacent to a third module pair 110c, which may be laterally adjacent to a fourth module pair 110d. The cage structure may include cavities 132 to receive the pluggable modules 108. The cavities 132 may be identical in size and shape and may have a perimeter slightly bigger than the perimeter of the pluggable modules 108. Cavity 132a may be a substantially rectangular negative space between the top internal surface 138 and first middle surface 140. Cavity 132b may be a substantially rectangular negative space between the second middle surface 142 and the bottom internal surface 144.

The cage structure may include a number of riding heatsinks corresponding to the number of cavities 132 for receiving pluggable modules. In the example of FIGS. 4-5 employing a 2x4 cage design, eight riding heatsinks 114 may be included, corresponding to the eight cavities 132. The cage structure may also include mounting holes 124 to connect the cage structure to the vertical line card 102, as described in further detail in connection with Figures 3A and 3B. This design fits 64 ports on 1 PCB assembly (PCBA) for a 4 Open Rack units (4OU) chassis configuration.

In other examples, the cage structure may include a 2 x n design, with two cage rows and any number of columns. The 2 x n cage for the belly-to-belly configuration may increase the mechanical strength of the cage structure 118 because the module pairs 110 are grouped together and because of the reduced number of perforations for mounting holes 124 on the vertical line card 102.

Other ganged cage configurations, which are module pairs grouped into multiple columns and system rows, are possible to support internal heatsink pluggable modules 108 with an additional riding heatsink. For example, the cage structure may include an additional system row, which is a row including two cage rows and therefore one module pair 110. Additional system rows increase the mechanical strength of the cage structure 118.

In examples for a 64-port switch with one ASIC 104, the vertical cage structure may include, but is not limited to, a 4x4 cage design with four system rows and four columns of module pairs 110, a 4x6 cage design with four system rows and six columns of module pairs 110, or a 4x8 cage design with four system rows and eight columns of module pairs 110.

In examples for a 128-port switch with one ASIC 104, the vertical cage structure may include, but is not limited to, a 2x8 cage design with two system rows and eight columns of module pairs 110, a 4x8 cage design with four system rows and eight columns of module pairs 110, a 6x8 cage design with six system rows and eight columns of module pairs 110, or an 8x8 cage design with eight system rows and eight columns of module pairs 110.

The cage structure may have any number of system rows and any number of columns of module pairs 110.

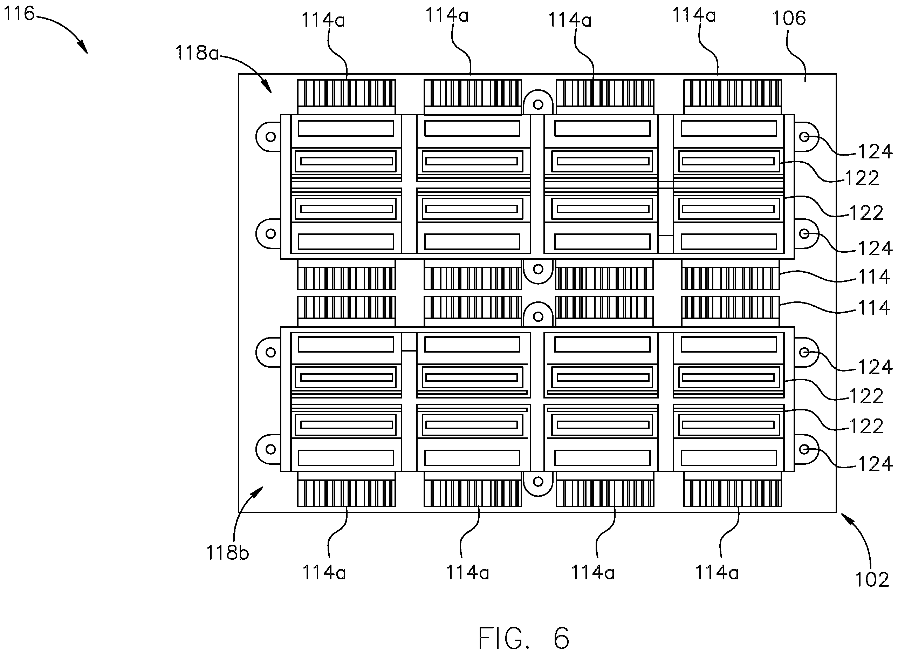

Figure 6 illustrates the cage assembly 116 having pluggable modules 108 in module pairs 110 plugged into cage structures 118 on the PCB 106 of the vertical line card 102. The vertical line card 102 may include two or more cage structures 118 aligned in two system rows. In the example shown, cage structure 118a may be positioned directly above and parallel to cage structure 118b on the vertical line card 102. In other examples, the relative positions of the cage structures may differ. For example, the cage structures may be laterally adjacent, unaligned, etc. In further examples, additional cage structures may be included. For example, while two cage structures 118a, 118b are shown in Fig. 6, the vertical line card 102 may include four, six, nine, or any other number of cage structures.

Figure 7 illustrates cutouts on the PCB 106 in the vertical line card 102. The cutouts may be sized and shaped to accommodate internal heatsinks and riding heatsinks. The positions of the cutouts may align with the positions of the heatsinks when the pluggable modules are inserted. For example, a first set of cutouts 128 may be sized, shaped, and positioned to accommodate the riding heatsinks, while a second set of cutouts 130 and 154 may be sized, shaped, and positioned to accommodate the internal heatsinks.

As shown in FIG. 7, the cutouts may be separate as distinct riding heatsink cutouts 128 and internal heatsink cutouts 130 and 154. In some examples, the PCB 106 may comprise the first internal heatsink cutout 130 between the top internal surface 138 and the first middle surface 140 and the second internal heatsink 154 cutout between the second middle surface 142 and the bottom internal surface 144.

In other examples, the cutouts may be combined as one larger cutout sized and shaped to accommodate both one riding heatsink 114 and one internal heatsink 112 in the pluggable module 108.

The present disclosure may be useful in high-speed switch implementations to maintain signal integrity and therefore may be used in high performance cooling applications, including, but not limited to, network switches, graphics processing units (GPUs), central processing units (CPUs), and AI superclusters.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

## Claims

1. A cage structure (118) comprising:
a first end and a second end, the first end adapted to be coupled to a vertical line card (102) such that the second end of the cage structure (118) is laterally displaced from the first end, the cage structure (118) having a top edge and a bottom edge extending between the first and second ends, and at least two vertically aligned cavities (132a,b) extending between the first end and the second ends and between the top edge and the bottom edge, each of the top edge and the bottom edge adapted to accommodate a riding heatsink (114a,b).

2. The cage structure (118) of claim 1, further comprising a middle edge between and parallel to the top and bottom edges, the middle edge comprising a first middle surface (140) facing the top edge and a second middle surface (142) facing the bottom edge, wherein the top edge comprises a top external surface (136) on a perimeter of the cage structure (118) and a top internal surface (138) facing the first middle surface (140), and wherein the bottom edge comprises a bottom internal surface (144) facing the second middle surface (142) and a bottom external surface (146) on the perimeter of the cage structure (118), and/or
wherein the at least two vertically aligned cavities (132a,b) comprise a first cavity (132a) between the top internal surface (138) and the first middle surface (140) and a second cavity (132b) between the second middle surface (142) and the bottom internal surface (144), and/or
wherein a first riding heatsink (114a) resides on the top external surface (136) and a second riding heatsink (114b) resides on the bottom external surface (146).

3. A cage assembly (116), comprising:
the cage structure (118) of claims 1 or 2; and
a module pair (110) encased within the cage structure (118), wherein the module pair (110) comprises two vertically aligned pluggable modules (108a,b) respectively residing within the at least two vertically aligned cavities (132a,b) of the cage structure (118).

4. The cage assembly (116) of claim 3, wherein a top one of the pluggable modules (108a) comprises a first internal heatsink (112a) between the top internal surface (138) and the first middle surface (140), the first internal heatsink (112a) facing the top internal surface (138) of the cage structure (118).

5. The cage assembly (116) of claims 3 or 4, wherein a bottom one of the pluggable modules (108b) comprises a second internal heatsink (112b) between the second middle surface (142) and the bottom internal surface (144), the second internal heatsink (112b) facing the bottom internal surface (144) of the cage structure (118).

6. The cage assembly (116) of claims 4 or 5, wherein the first and second internal heatsinks (112a,b) are parallel to the first and second riding heatsinks (114a,b).

7. The cage assembly (116) of any one of claims 3 to 6, wherein the first riding heatsink (114a) has a first thickness and the second riding heatsink (114b) has a second thickness different from the first thickness.

8. A system for cooling a vertical line card (102) comprising:
a printed circuit board (PCB) (106);
an application specific integrated circuit (ASIC) (104) mountable on the PCB (106) on a vertical line card (102) such that the ASIC (104) and the PCB (106) both extend along a vertical plane; and
the cage assembly (116) of any one of claims 3 to 7.

9. The system of claim 8, wherein each pluggable module (108a,b) comprises an internal heatsink (112a,b) parallel to the two riding heatsinks (114a,b), and wherein the internal heatsinks (112a,b) of the two pluggable modules (108a,b) face at least one of the top edge and the bottom edge of the cage structure (118).

10. The system of claims 8 or 9, wherein the PCB (106) comprises a first internal heatsink cutout (130) between the top internal surface (138) and the first middle surface (140) and a second internal heatsink cutout (154) between the second middle surface (142) and the bottom internal surface (144).

11. The system of claim 10, wherein a space between the first and second internal heatsink cutouts (130, 154) on the PCB (106) defines a routing space.

12. The system of any one of claims 8 to 11, wherein each pluggable module (108a,b) comprises an optical connector on an end of each pluggable module (108a,b), the optical connector configured to establish a data path between the pluggable module (108a,b) and traces of the PCB (106).

13. The system of any one of claims 8 to 12, further comprising at least one second module pair (110) laterally adjacent to the first module pair (110).

14. The system of any one of claims 8 to 13, wherein the cage assembly (116) is positioned relative to a first edge of the ASIC (104), and a second cage assembly (116) is positioned relative to a second opposing edge of the ASIC (104), and/or
wherein the at least two vertically aligned cavities (132a,b) are sized to accommodate the module, and/or
wherein the cage assembly (116) comprises at least two additional vertically aligned cavities (132a,b) positioned laterally adjacent to the at least two vertically aligned cavities (132a,b).

15. The system of any one of claims 8 to 14, wherein the cage assembly (116) comprises four pairs of vertically aligned cavities (132a,b), the cavities (132a,b) forming a 2 x 4 configuration.
